# EUROPÄISCHE PATENTSCHRIFT

(11) **EP 1 604 379 B1**
(45) Veröffentlichungstag und Bekanntmachung des Hinweises auf die Patenterteilung: **11.01.2012**
(21) Anmeldenummer: 04718624.2
(22) Anmeldetag: 09.03.2004
(51) Int. Cl.: H01H 13/70, G06F 3/033, H03M 11/24

(54) **STUFENLOS BETÄTIGBARE TASTEN EINER TASTATUR MIT INTEGRIERTEM SIGNALERFASSUNGSELEMENT UND VERFAHREN ZUR SIGNALVERARBEITUNG**
CONTINUOUSLY ACTUATABLE KEYS PERTAINING TO A KEYBOARD COMPRISING AN INTEGRATED SIGNAL DETECTION ELEMENT, AND METHOD FOR SIGNAL PROCESSING
TOUCHES D'UN CLAVIER ACTIONNABLES EN CONTINU ET COMPORTANT UN ELEMENT INTEGRE DE DETECTION DE SIGNAUX ET PROCEDE DE TRAITEMENT DE SIGNAUX

(30) Priorität: 12.03.2003 DE 10311294
(43) Veröffentlichungstag der Anmeldung: 14.12.2005
(73) Patentinhaber: Völckers, Olivier, 14055 Berlin (DE)
(72) Erfinder: Völckers, Olivier, Berlin (DE)
(74) Vertreter: Burghardt, Dieter
(86) Internationale Anmeldenummer: PCT/EP2004/002392
(87) Internationale Veröffentlichungsnummer: WO 2004/081958

(56) Entgegenhaltungen:
- EP-A- 0 136 630
- US-A- 4 975 676
- US-A- 4 987 372
- US-A- 5 550 339
- US-A- 5 815 139
- US-B1- 6 377 685

## Beschreibung

Die Erfindung betrifft eine Tastatur mit drück- und kippbar beweglich angeordneten Tasten, die mit einem die Tastenbetätigung registrierenden Signalerfassungselement ausgerüstet ist und ein Verfahren mit dem diese durch Betätigung der Tasten ausgelösten elektrischen Impulse durch Ermittlung der Kraft und Position der Betätigung der Tasten in die Position der Betätigung kennzeichnende Signale umgesetzt werden.

Nach dem Stand der Technik werden Tastaturen und Eingabegeräte zur Cursorsteuerung üblicherweise als getrennte Einheiten konzipiert, so dass deren Kombination eine doppelte Auswertungselektronik und Software erfordert.

Bei Notebook-Computern etwa wird häufig ein kleiner Joystick in der Nähe der Leertaste angebracht, um den Mauszeiger zu steuern. Dieser Joystick kann z.B. auf der Basis von Dehnungsmessstreifen (engl. Strain Gauges) realisiert werden. Außerdem wird bei Notebook-Computern oft ein flächenförmiger Sensor auf kapazitiver Basis zur Maussteuerung benutzt. In beiden Fällen ist der technische Aufwand zur Auswertung der komplexen Signale erheblich.

Bei Mobiltelefonen mit Organizer-Funktionen, sog. Smartphones, ist eine technische Lösung bekannt, auf einem berührungsempfindlichen Bildschirm (Touchscreen) ein klappbare Tastatur anzubringen. Wird das Gerät zur Dateneingabe genutzt, dann können die Tasten auf den Touchscreen gelegt werden und jede Tastenbetätigung aktiviert dann eine spezifische Position des Touchscreens. Dies erspart eine separate Elektronik zur Tastenauswertung. Allerdings kann mit dem Klappmechanismus nur entweder die Tastatur oder der Touchscreen genutzt werden.

Weiterhin gibt es zahlreiche Vorschläge zur Erweiterung von Tastaturen wie z.B. das US Patent 5,973,621 (David Levy 1999) oder das US Patent 5,528,235 (Edward Lin 1991). Solche Erweiterungen auf der Basis elektrischer Schalter sind mechanisch aufwendig und störanfällig und haben sich daher bisher nicht durchsetzen können.

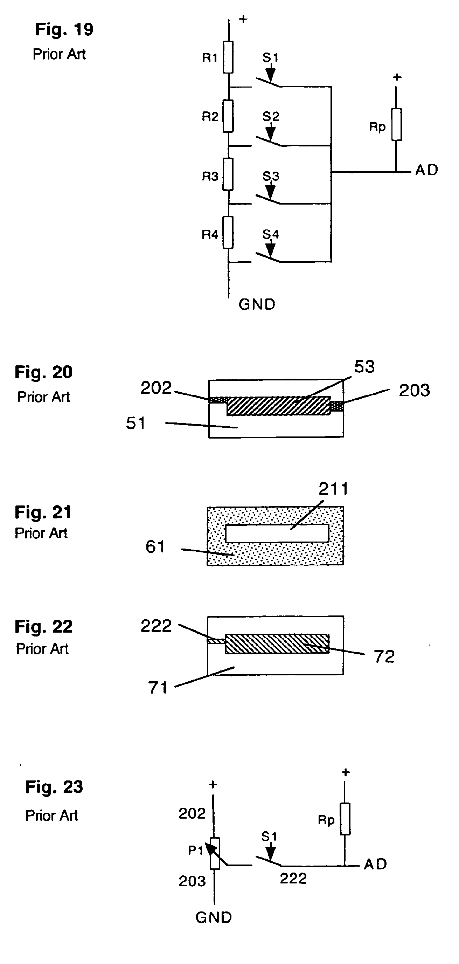

Es ist eine bekannte Technik, Tasten durch Analogwerte mit Hilfe eines Spannungsteilers zu kodieren (Fig. 19). An den Widerständen R1, R2, R3 und R4 liegt jeweils eine spezifische Spannung an. Die Betätigung eines Tasters S1, S2, S3 oder S4 leitet diese Spannung zu einem Analog/Digital-Wandler (AD). Ist kein Taster betätigt und somit kein Kontakt geschlossen, liegt an AD durch den Pullup-Widerstand Rp eine positive Spannung an.

So kann die gesamte Tastatur mit nur zwei oder drei Leitungen abgefragt werden. Diesem geringen Leitungsaufwand steht jedoch der höhere Aufwand für die Dekodierung mit einem Analog/Digital-Wandler gegenüber. Der Einsatz dieser Technik beschränkt sich daher auf die Fälle. in denen eine geringe Zahl von Leitungen einen wesentlichen Vorteil bringt.

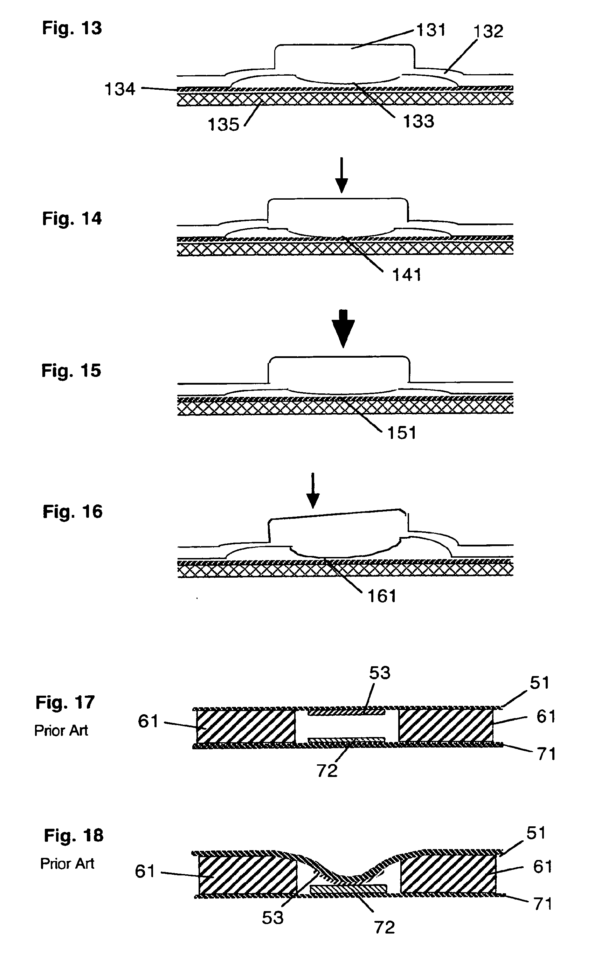

Eine weitere bekannte Technik ist die der Folienpotenziometer (Fig. 17, Schnitt-Darstellung). Sie bestehen in der einfachsten Form aus einem Streifen biegsamer Folie 51, die teilweise mit einem Material von hohem elektrischen Widerstand (100 Ohm bis ca. 500 Kiloohm pro 10cm) wie z.B. Graphit 53 beschichtet ist, einer zweiten Folie 71, die teilweise mit einem gut elektrischen Strom leitenden Material 72 wie z.B. Silber beschichtet ist (weniger als rund 10 Ohm pro 10 cm) und drittens einem Abstandhalter 61, der beide Beschichtungen im Ruhezustand in einem Abstand von ca. 0,02 mm bis 1,0 mm hält. Der Abstandhalter 61 verfügt über eine Öffnung 211, die bei mechanischem Druck eine Kontaktierung der leitenden Beschichtungen 53 und 72 ermöglicht. Am Rand der Folien 51 und 71 ist die Beschichtung mit Elektroden 202 und 203 verbunden (Fig. 20, Ansicht von oben). Eine weitere Elektrode 222 befindet sich an der Beschichtung der Folie 71 (Fig. 22, Ansicht von oben). Die Elektroden ermöglichen eine Kontaktierung mit einer Auswerteelektronik. Bei Betätigung (Fig. 18) verbiegt sich die flexible Folie 51 geringfügig an der berührten Position, so dass der Abstandhalter 61 überbrückt wird und ein elektrischer Kontakt zwischen 53 und 72 entsteht. Der elektrische Widerstand zwischen den Elektroden 202/203 der widerstandbeschichteten Folie 51 einerseits und der Elektrode 222 an der Folie 71 andererseits verhält sich nun proportional zu dem Abstand zwischen dem Kontaktpunkt und deren Enden.

Wird das Folienpotenziometer als Spannungsteiler beschaltet (Fig. 23), so verhält sich die Spannung am Analog-Digital-Wandler AD proportional zu der Position des Abgreifpunkts.

Alternativ lassen sich sowohl Auslösepunkt als auch die Länge der Auflagestrecke bestimmen. Dazu wird eine Spannung an die Elektrode 222 angelegt und der Ohmsche Widerstand zu den beiden Elektroden 202 und 203 gemessen. Die beiden Messwerte entsprechen den Abständen zu den beiden Enden, während die Summe beider Messwerte subtrahiert von dem Gesamtwiderstand zwischen 202 und 203 die Länge der aktivierten Strecke ergibt. Die Aktivierung an einer Strecke oder an zwei Punkten anstelle eines einzelnen Punktes erzeugt nämlich einen Kurzschluss zwischen beiden Punkten, der den Widerstand zwischen 202 und 203 proportional zu dem Abstand dieser Punkte verringert. Auch dies gehört zum Stand der Technik bei Folienpotenziometern.

Während Folienpotenziometer auf einfache Weise stufenlose Einstellungen ermöglichen, bieten sie durch die flache Bauform keine fühlbare Rückmeldung. Daher bieten sie keine komfortable Dateneingabe wie herkömmliche Tastaturen und haben bislang nur geringe Verbreitung erfahren.

Ebenfalls bekannt ist eine Tastatur nach EP 0 136 630 A2, die mechanisch bewegliche Tasten mit einem Widerstandsstreifen so kombiniert, dass die Tasten an der Unterseite bei Betätigung Kontakte mit einem Widerstandsstreifen schließen. Ein A/D-Wandler misst die Spannung und jeder Messwert ist einer bestimmten Taste zugeordnet. Da jedoch keine Zuordnung zur Betätigungsposition auf dieser Taste, keine Messung der Andruckstärke oder der Schrägstellung vorgesehen sind, sind bei mehrfachbelegten TastenMehrfachbetätigungen nötig. Weiterhin ermöglicht auch diese Tastatur keine stufenlose Steuerung.

Das Ziel dieser Erfindung ist es, den Herstellungsaufwand von kompakten mobilen elektronischen Geräten, die mit Tasten von Bedienelementen versehen sind, durch Senkung des Volumens und des Gewichtes, den Teileaufwand sowie den Energieverbrauch und den Bedienaufwand zu senken, wobei die Tastatur robust gegenüber rauhen Transportbedingungen und Herstellungstoleranzen sein muß.

Der Erfindung liegt die Aufgabe zugrunde, eine für den Einsatz in kompakten mobilen elektronischen Geräten geeignete Tastatur mit einem integrierten Signalerfassungselement, die eine Dateneingabe mit uneingeschränktem Komfort und zugleich eine stufenlose Steuerungsmöglichkeiten mit einer Vielzahl von Tasten erlaubt, eine Abfrageelektronik für die Tastenbetätigung und ein Verfahren zur Auswertung einer momentanen Tastenposition bei einer stufenlosen Betätigung von einzelnen Tasten zu entwickeln.

Diese Aufgabe wird durch die im kennzeichnenden Teil genannten Merkmale der unabhängigen Patentansprüche gelöst.

Die Erfindung soll an einem Ausführungsbeispiel näher erläutert werden. In der zugehörigen Zeichnung zeigen:
- Fig.1:: Schaltplan einer erfindungsgemäßen Tastatur zur Spannungsmessung mit einem AD-Wandler,
- Fig.2:: Schaltplan einer erfindungsgemäßen Tastatur zur Widerstandsmessung mit zwei AD-Wandlern,
- Fig. 3: Schaltplan einer erfindungsgemäßen Tastatur zur Widerstandsmessung mit drei AD-Wandlern,
- Fig. 4: Schaltplan einer erfindungsgemäßen Tastatur zur Spannungsmessung und zwei Kalibrations-Elektroden,
- Fig. 5: Obere Folie des Signalerfassungselements mit aufgedruckten Leiterbahnen,
- Fig. 6: Mittlere Folie des Signalerfassungselements mit ausgestanzten Öffnungen,
- Fig. 7: Untere Folie des Signalerfassungselements mit aufgedruckten Leiterbahnen,
- Fig. 8: Beispiel einer Tastenabdeckung mit Beschriftung,
- Fig. 9: Obere Folie des Signalerfassungselements mit aufgedruckten Leiterbahnen,
- Fig. 10: Mittlere Folie des Signalerfassungselements mit ausgestanzten Öffnungen,
- Fig. 11: Untere Folie des Signalerfassungselements mit aufgedruckten Leiterbahnen,
- Fig. 12: Beispiel einer Tastenabdeckung mit Beschriftung,
- Fig. 13: Taste mit Aktivator (Schnitt-Darstellung),
- Fig. 14: Taste im leicht gedrückten Zustand (Schnitt-Darstellung),
- Fig. 15: Taste im stark gedrückten Zustand (Schnitt-Darstellung),
- Fig. 16: Taste im schräg gedrückten Zustand (Schnitt-Darstellung),
- Fig. 17: Aufbau eines Folienpotenziometers (Schnitt-Darstellung),
- Fig. 18: Folienpotenziometer im betätigten Zustand (Schnitt-Darstellung),
- Fig. 19: Tastatur mit Kodierung durch Widerstands-Kaskade,
- Fig. 20: Folienpotenziometer, obere Folie,
- Fig. 21: Folienpotenziometer, mittlere Folie,
- Fig. 22: Folienpotenziometer, untere Folie,

Die Lösung besteht darin, ein Signalerfassungselement, z. B. ein Folienpotenziometer so unterhalb einer Gruppe von beweglichen Tasten zu montieren, dass eine gedrückte Taste jeweils einem charakteristischen elektrischen Widerstand an den Elektroden des Folienpotenziometers zugeordnet werden kann. Die Schrägstellung einer Taste bzw. eine variable Berührposition auf der Taste führt zu einem unterschiedlichen Kontaktpunkt und damit zur Veränderung des elektrischen Widerstands. Wenn dagegen keine Taste ausgelöst ist, entsteht auch kein elektrischer Kontakt zwischen den gegenüber liegenden Elektroden.

Zusätzlich kann optional die Andruckkraft jeder Taste dadurch bestimmt werden, dass die Verringerung des Gesamt-Widerstandes des Folienpotenziometers gemessen wird. Da eine erhöhte Andruckkraft auf eine Taste mit einer Verformung der weichen Tastenunterseite, einer vergrößerten Auflagefläche und einem entsprechend verringerten Gesamt-Widerstand einher geht, lässt sich aus der Widerstands-Differenz auf die Andruckkraft schließen.

Auf diese Weise kann, eine ausreichende Messgenauigkeit vorausgesetzt, eine Vielzahl von Tasten einschließlich ihrer Auslöseposition über ein einziges Folienpotenziometer abgefragt werden. Dazu werden nur eine geringe Zahl von Leitungen benötigt (mind. zwei ohne Kraftmessung, drei mit Kraftmessung).

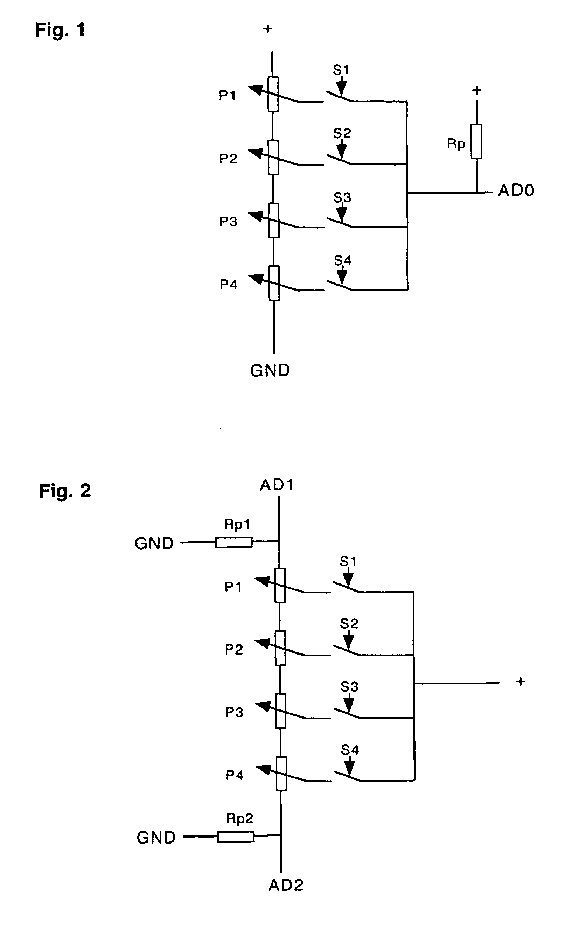

Fig. 1 zeigt die Beschaltung einer erfindungsgemäßen Tastatur. P1-S1, P2-S2 usw. bilden jeweils Einheiten: Ein Tastendruck schließt z.B. den Kontakt S1 und der Widerstand des Potenziometers P1 ergibt sich aus der Betätigungsposition. Rp ist ein Pullup-Widerstand, der im kontaktlosen Ruhezustand den Eingang des Analog-Digital-Wandlers AD auf einen definierten Wert zieht. Das durch P1 bis P4 gebildete Folienpotenziometer entspricht einem Spannungsteiler, so dass am AD-Wandler eine der Taste und Position entsprechende spezifische Spannung anliegt. Das Beispiel ist für vier Tasten ausgelegt, gilt aber genauso für eine beliebige andere Tastenzahl.

In Fig. 2 ist zu sehen, wie die gleiche Tastatur durch eine andere Mess-Anordnung ausgewertet werden kann. Durch einen zusätzlichen AD-Wandler lässt sich auch die auf eine Taste wirkende Andruckkraft bestimmen. Eine stärkere Andruckkraft führt zu einer Verformung der weichen Tastenunterseite und damit zu einer vergrößerten Auflagefläche auf dem Folienpotenziometer, d.h. einer Kurzschluss-Strecke. Nun wird mit Hilfe der AD-Wandler AD1 und AD2 der elektrische Widerstand zwischen der ausgelösten Taste S1 bis S4 und AD1 bzw. AD2 gemessen und ins Verhältnis zu dem Gesamtwiderstand von P1 bis P4 im Ruhezustand gesetzt. Diese Herabsetzung des Widerstands entspricht genau der Kurzschluss-Strecke, damit der Auflagefläche der weichen Tastenunterseite und damit der Betätigungskraft.

Fig. 1 und Fig. 2 beschreiben Anordnungen, bei denen eine stufenlose Betätigung von beliebigen Tasten auf einer einzelnen Achse ausgewertet wird. Dies entspricht einer seitlichen Bewegung der Auslöseposition oder der schrägen Betätigung einer Taste.

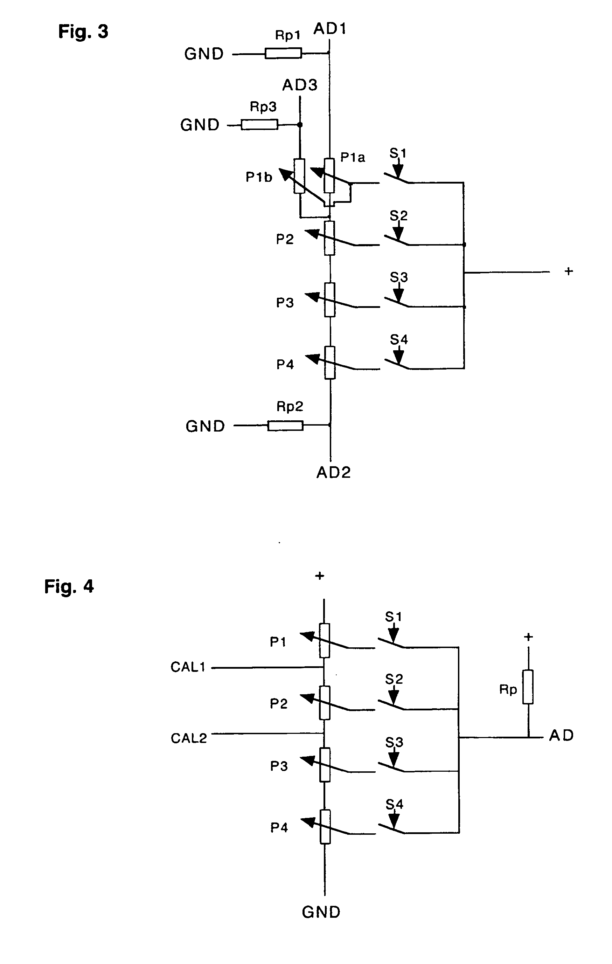

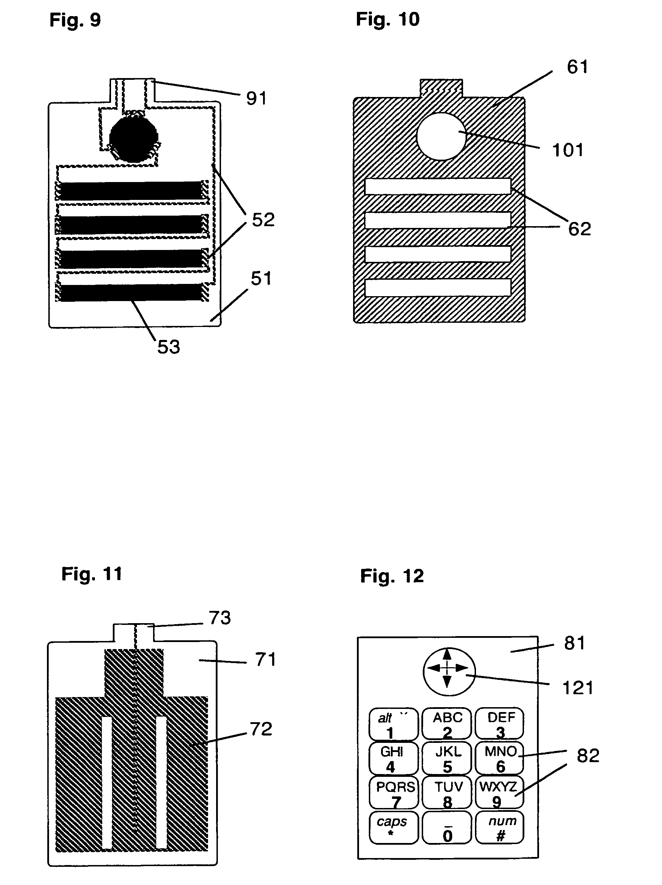

Fig. 3 zeigt, wie für ausgewählte Tasten auch eine Auswertung in zwei Achsen möglich ist, wenn dafür zusätzliche AD-Wandler zur Verfügung stehen. Hier bilden P1a und P1b zwei Potenziometer, die durch eine einzige Taste gesteuert werden (Fig. 12, Element 121). Drei Messpunkte am Rand eines Kreises genügen, um den Schwerpunkt einer Kontaktierung zu bestimmen; nämlich den Punkt auf der Kreisfläche, der zu den drei Messpunkten jeweils den berechneten Abstand hat.

Um die Zuverlässigkeit und Genauigkeit zu erhöhen, ist es möglich, an einem oder mehreren Positionen der Tastatur Referenzpunkte vorzusehen. In Fig. 4 dienen CAL1 und CAL2 als Kalibrations-Werte zur Messung mit einem AD-Wandler; der Wert von CAL1 liegt direkt zwischen P1 und P2, während der Wert von CAL2 direkt zwischen P2 und P3 liegt. Die Kalibration kann erfolgen, wenn keine Taste betätigt wird. Die Referenzpunkte zeigen präzise ein relatives Verhältnis zu den Tasten-Auslösungen an, auch wenn der Gesamt-Widerstand durch Temperaturen o.ä. schwanken sollte.

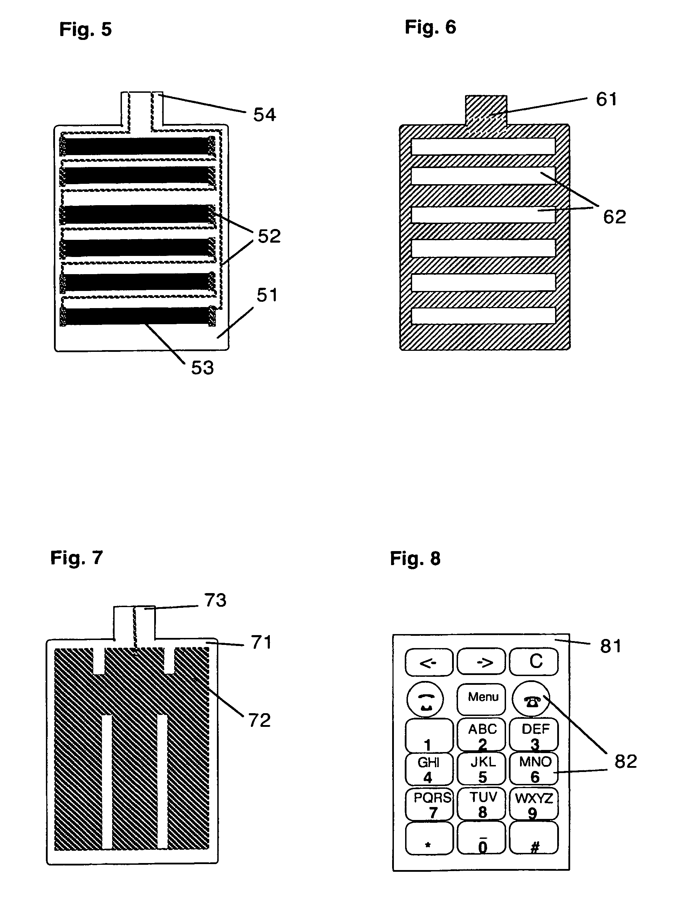

Als Signalerfassungselement der erfindungsgemäßen Tastatur kann ein Folienpotenziometer dienen. Als Beispiel ist in Fig. 5-7 ein Folienpotenziometer dargestellt, das aus drei Folien besteht: einer oberen (Fig. 5), einer mittleren (Fig. 6) und einer unteren (Fig. 7). Diese drei Folien liegen flach über einander und sind fest miteinander verbunden, z.B. verklebt. Die mittlere Folie kann auch durch eine gedruckte Isolationsschicht (Dielektrikum) ersetzt werden, die entweder auf der oberen oder der unteren Folie aufgebracht sein kann. Die obere Folie (Fig. 5, 51) ist mit Leiterbahnen aus einem gut leitenden Material 52 und Leiterbahnen aus einer Widerstandsschicht 53 bedruckt. An einem Ende befindet sich eine Kontaktleiste 54, um die elektrische Verbindung zu einer Mess-Elektronik herzustellen.

Die mittlere Folie (Fig. 6, 61) enthält Aussparungen (Öffnungen) 62, die einen mechanischen und elektrischen Kontakt zwischen der oberen und der unteren Folie ermöglichen. Die untere Folie (Fi. 7, 71) ist mit Leiterbahnen mit geringem elektrischen Widerstand 72 bedruckt.

In Fig. 8 ist als Beispiel eine Tastenanordnung zu sehen, die mit dem Folienpotenziometer aus Fig. 5-7 funktioniert. Diese Tasten sind mechanisch hervorgehoben und mit einem Klick beweglich ausgelegt.

Fig. 9-12 entsprechen Fig. 6-9 mit dem Unterschied, dass eine in zwei Dimensionen bewegliche Taste eine zusätzliche Leitung und einen zusätzlichen AD-Wandler erfordert. Die Taste 121 kann sowohl in horizontaler als auch in vertikaler Richtung geneigt werden und diese Neigung kann gemessen werden.

Fig. 13 zeigt eine Taste in der Schnittdarstellung, im Zustand ohne Aktivierung. Der Aktivator 133 hat keinen mechanischen Kontakt mit dem Signalerfassungselement (Folienpotenziometer) 134.

Fig. 14 zeigt die gleiche Taste wie Fig. 13, jedoch im gedrückten Zustand. Der Aktivator 133 liegt in der Mitte der Taste 141 auf und stellt einen entsprechenden elektrischen Kontakt her. Wenn der Druck erhöht wird, wie in Fig. 15 sichtbar, dann vergrößert sich die Auflagefläche des Aktivators (151). Der elektrische Widerstand des Gesamtsystems würde durch diesen kleinen Kurzschluss sinken.

In Fig. 16 ist die Taste seitlich geneigt ausgelöst worden, was bei dieser Tastatur trotzdem zu einem sicheren Kontakt führt. Die Position des Kontakts lässt sich über die entsprechenden Messungen bestimmen.

Als Anwendungen für die stufenlos betätigbaren Tasten bieten sich folgende an: Bei einer numerischen Telefon-Tastatur in der Art von Fig. 8 können z.B. Buchstaben eingegeben werden, indem sie direkt auf der Taste angetippt werden, d.h. auf die linke Seite der Taste "2" drücken, um ein "A" einzugeben usw.. Außerdem kann ein Cursor-Steuerkreuz (Fig.12) stufenlos gesteuert werden.

Der Vorteil des Gegenstandes der Erfindung liegt darin, dass die Tastenabfrage und eine stufenlose Steuerungsfunktion mit einer einheitlichen Technik kombiniert ist. Jede Tastenbewegung führt durch Messung der Kraft und Position der Betätigung zu einem spezifischen elektrischen Widerstand des Ausgabesignals, das die Position der Betätigung kennzeichnet. Wenn ein zweites Ausgabesignal ausgewertet wird, kann zusätzlich die ausgeübte Kraft der Betätigung bestimmt werden. Der nötige technische Aufwand für die vorgeschlagene Lösung ist damit deutlich geringer als bei herkömmlichen Tastaturen mit stufenlosen Steuereinheiten.

### Aufstellung der Bezugszeichen

- AD0: Analog-Digital-Wandler
- P1 mit S1: Signalerfassungselement
- P2 mit S2: Signalerfassungselement
- P3 mit S3: Signalerfassungselement
- P4 mit S4: Signalerfassungselement
- Rp: Pullup-Widerstand

- 51: Obere Folie
- 52: Leiterbahnen mit geringem elektrischen Widerstand (z.B. Silber)
- 53: Leiterbahnen mit hohem Widerstand, z.B. Graphit
- 54: Kontaktleiste mit insgesamt drei Anschlüssen

- 61: Abstandshalter
- 62: Öffnungen des Abstandshalters

- 71: Untere Folie
- 72: Leiterbahn-Fläche mit geringem elektrischen Widerstand, z.B. Silber
- 73: Kontaktleiste

- 81: Gehäuseabdeckung
- 82: Bewegliche Tasten

- 91: Kontaktleiste mit insgesamt vier Anschlüssen

- 101: runde Öffnung für in beliebiger Richtung betätigbare Taste

- 121: Taste, die in beliebiger Richtung betätigt werden kann

- 131: Tastenoberseite
- 132: Tastenaufhängung
- 133: Aktivator
- 134: Signalerfassungselement
- 135: Trägerplatte

- 141: kleine Auflagefläche in der Tastenmitte

- 151: größere Auflagefläche in der Tastenmitte

- 161: kleine Auflagefläche an der Tastenseite

- 202: Elektrode
- 203: Elektrode

- 211: Öffnung
- 222: Elektrode

## Patentansprüche

1. Tastatur mit drück- und kippbar stufenlos betätigbaren Tasten (82) und mit integriertem Signalerfassungselement, insbesondere für mobile elektronische Geräte, zur Dateneingabe und zur Cursorsteuerung und Funktionsauswahl, mit beweglich angebrachten und mit einer Federung (132) versehenen Tasten (82), die an ihrer Unterseite mit einer kontinuierlichen, sich über eine oder mehrere Tasten erstreckenden Leiterbahn mit hohem elektrischen Widerstand (53) so mechanisch gekoppelt sind, dass bei einer Betätigung der Tasten die Leiterbahn (53) an der Betätigungsposition eine weitere über sämtliche Tasten erstreckende Leiterbahn mit geringem elektrischen Widerstand (72) berührt und ein Analog-Digital-Wandler AD0 den elektrischen Widerstand oder Spannungsabfall zwischen der Leiterbahn (72) und einem Ende der Leiterbahn (53) bestimmt, wobei dieser Messwert von einer Steuerelektronik ausgewertet und dadurch einer bestimmten Taste und der Betätigungsposition auf dieser Taste zugeordnet wird.

2. Tastatur nach Anspruch 1, ***dadurch gekennzeichnet*, dass** zwei den elektrischen Widerstand oder Spannungsabfall zwischen der Leiterbahn (72) und beiden Enden der Leiterbahn (53) bestimmende Analog-Digital-Wandler AD1 und AD2 vorgesehen sind, wobei diese Messwerte eindeutig einer bestimmten Taste, der Betätigungsposition als Punkt auf einer Linie und der Auflagefläche (141), (151), (161) zugeordnet werden.

3. Tastatur nach Anspruch 1, ***dadurch gekennzeichnet*, daß** die Leiterbahn (53) mit einer oder mehreren Kalibrations-Elektroden CAL1 verbunden sind, die eine exakte Messung des elektrischen Widerstands an mehreren Positionen der Leiterbahn (53) ermöglichen, wobei diese Messungen als relative Bezugspunkte zur Interpretation der Messwerte an den Enden der Leiterbahn (53) dienen, so dass auch bei produktionstechnischen oder temperaturbedingten Schwankungen des elektrischen Widerstands der gesamten Leiterbahn eine genaue Messung möglich ist.

4. Tastatur nach Anspruch 1, ***dadurch gekennzeichnet,* dass** die Leiterbahn (53) des Folienpotenziometeres als Bestandteil einer Tastatur in mehrere parallel zu einander liegenden Zeilen unterteilt ist, wobei die einen Enden dieser Zeilen jeweils über eine Leiterbahn mit geringem elektrischen Widerstand (52) mit dem gegenüber liegenden Ende der nächsten Zeile verbunden sind, so dass produktionsbedingte, geringfügige Schwankungen der Montageposition der Tasten (82) auf dem Folienpotenziometer bei jeder Taste zu der gleichen Abweichung der Messwerte führt.

5. Tastatur nach Anspruch 1, ***dadurch gekennzeichnet,* dass** das Folienpotenziometer als Bestandteil einer Tastatur aus einer obere Folie (51), einen Abstandhalter (61) und eine untere Folie (71) besteht, die fest miteinander verbunden sind, wobei die obere Folie (51) mit Leiterbahnen mit einem hohen elektrischen Widerstandswert (53) sowie optional mit Leiterbahnen mit einem geringen elektrischen Widerstandswert (52) bedruckt sind und die untere Folie (71) mit einer Leiterbahn mit einem geringe elektrischen Widerstandswert (72) bedruckt ist, wobei die Leiterbahnen (53) und (72) in der Ruheposition einen geringen Abstand von weniger als 2 mm von einander halten und sich bei der Betätigung von Tasten (82) berühren.

6. Tastatur nach Anspruch 1, ***dadurch gekennzeichnet,* dass** drei den elektrischen Widerstand oder Spannungsabfall zwischen der Leiterbahn (72) und drei Enden der Leiterbahn (53) (Fig. 9) bestimmende Analog-Digital-Wandler AD1, AD2 und AD3 vorgesehen sind, wobei diese Messwerte eindeutig einer bestimmten Taste, der Betätigungsposition als Punkt auf einer Kreisfläche und der Auflagefläche (141), (151), (161) zugeordnet werden.

7. Tastatur nach Anspruch 1, ***dadurch gekennzeichnet,* dass** die Tasten (82) wie bei einer numerischen Telefon-tastatur jeweils mit einer Ziffer oder Zeichen und mehreren Buchstaben des Alphabets pro Taste beschriftet sind, wobei je nach Betriebsart Ziffern oder Buchstaben eingegeben werden können und unterschiedliche Buchstaben je nach Betätigung der Taste am linken oder rechten Rand der Taste oder der Tastenmitte gewählt werden können.

8. Tastatur nach Anspruch 1 und 6, ***dadurch gekennzeichnet,* dass** eine an jeder Position ihres Randes betätigbare Taste (121) vorgesehen ist, wobei die Richtung der Betätigung und die Stärke der Auslenkung als Punkt auf einer Kreisfläche durch das Verhältnis der Ausgabesignale AD1, AD2 und AD3 (Fig. 3) zueinander ermittelbar ist, und die Richtung und Geschwindigkeit einer Cursorbewegung durch die Richtung und Auslenkung dieser Taste (121) steuerbar ist.

9. Tastatur nach Anspruch 1, ***dadurch gekennzeichnet,* dass** die Tasten (82) über eine Tastenoberseite (131), eine verformbare, konvexe Tastenunterseite (133) und eine flexible Aufhängung (132) verfügen, so dass ein mechanischer Druck von oben ein auf einer Trägerplatte (135) liegendes Signalerfassungselement (134) an einer von der Auslöseposition abhängigen Position und mit einer vom ausgeübten Druck abhängigen Auflagefläche (141), (151), (161) aktiviert.

10. Verfahren zur Auswertung der Signale einer Tastatur nach Anspruch 1, ***dadurch gekennzeichnet,* dass** die Tasten bei einer leichten Berührung zu einer Darstellung mehrerer Eingabealternativen auf einem Display führen, wobei eine dieser Eingabealternativen durch einen Cursor hervorgehoben ist und die Position des Cursors im Verhältnis zur Fingerposition auf der Taste steht.

11. Verfahren zur Auswertung der Signale einer Tastatur nach Anspruch 1 und 10, ***dadurch gekennzeichnet,* dass** die angezeigte Eingabealternative beim Loslassen der Taste ausgewählt wird.

12. Verfahren zur Auswertung der Signale einer Tastatur nach Anspruch 1 und 10, ***dadurch gekennzeichnet*, dass** die angezeigte Eingabealternative durch erhöhten Druck auf eine Taste ausgewählt wird.

## Claims

1. A key pad with depressible and tiltable, steplessly operable keys (82) and an integrated signal recording element, in particular for mobile electronic devices, for data input and for cursor control and function selection, the key pad comprising movably attached and spring (132) loaded keys (82) which, on their underside, are mechanically coupled to a continuous conductor track of high electrical resistance (53) extending across one or several keys in such a way that when the keys are operated, the conductor track (53) contacts a further conductor track of low electrical resistance (72) extending across all the keys in the operation position, and an analogue-to-digital converter AD0 determines the electrical resistance or voltage drop between the conductor track (72) and one end of the conductor track (53), wherein this measured value is analysed by a control electronics and is thereby allocated to a certain key and to the operating position on this key.

2. Key pad according to claim 1, **characterised in that** two analogue-to-digital converters AD1 and AD2 are provided, which determine the electrical resistance or voltage drop between the conductor track (72) and both ends of the conductor track (53), wherein these measured values are unequivocally allocated to a certain key, to the operating position as a point on a line and to the supporting surface (141), (151), (161).

3. Key pad according to claim 1, **characterised in that** the conductor track (53) is connected to one or several calibration electrodes CAL1 which permit an exact measurement of the electrical resistance to be taken at several positions of the conductor track (53), wherein these measurements serve as relative reference points for interpreting the measured values at the ends of the conductor track (53), so that even if the electrical resistance of the entire conductor track fluctuates because of production-technical or temperature-dependent reasons the measurements taken are accurate.

4. Key pad according to claim 1, **characterised in that** the conductor track (53) of the foil potentiometer, as part of a key pad, is divided into several lines running parallel to each other, wherein one end of each of these lines is connected, via a conductor track of low electrical resistance (52), to the opposite end of the next line, so that production-dependent, small fluctuations of the mounting position of the keys (82) on the foil potentiometer at each key result in the same deviation of the measured values.

5. Key pad according to claim 1, **characterised in that** the foil potentiometer, as part of a key pad, consists of an upper foil (51), a spacer (61) and a lower foil (71) which are firmly connected to each other, wherein the upper foil (51) has conductor tracks of high electrical resistance value (53) and, optionally, conductor tracks of low electrical resistance value (52) printed on it, and the lower foil (71) has a conductor track of low electrical resistance value (72) printed on it, wherein the conductor tracks (53) and (72), in the idle position, keep a small distance of less than 2 mm from each other and contact each other when the keys (82) are operated.

6. Key pad according to claim 1, **characterised in that** three analogue-to-digital converters AD1, AD2 and AD3 are provided, which determine the electrical resistance or voltage drop between the conductor track (72) and three ends of the conductor track (53) (fig. 9), wherein these measured values are unequivocally allocated to a certain key, to the operating position as a point on a circular surface and to the supporting surface (141), (151), (161).

7. Key pad according to claim 1, **characterised in that** the keys (82), as with a numerical telephone key pad, are respectively labelled with a digit or a character and several letters of the alphabet per key, wherein depending on the mode of operation digits or letters can be entered and different letters can be selected according to the operation of the key on the left edge or the right edge of the key or in the centre of the key.

8. Key pad according to claim 1, **characterised in that** a key (121) operable at each position of its edge is provided, wherein the direction of operation and the strength of deflection as a point on a circular surface are ascertainable by the relationship between the output signals AD1, AD2 and AD3 (fig. 3) to each other, and wherein the direction and speed of a cursor movement is controllable by the direction and deflection of this key (121).

9. Key pad according to claim 1, **characterised in that** the keys (82) have a key topside (131), a deformable convex key underside (133) and a flexible suspension (132), so that a mechanical pressure from above activates a signal recording element (134) lying on a carrier plate (135) at a position dependent upon the trigger position and with a supporting surface (141), (151), (161) dependent upon the exercised pressure.

10. Method for analysing the signals of a key pad according to claim 1, **characterised in that** the keys when lightly touched, result in a presentation of several input alternatives on a display, wherein one of these input alternatives is highlighted by a cursor and the position of the cursor is related to the finger position on the key.

11. Method for analysing the signals of a key pad according to claim 1 and claim 10, **characterised in that** the displayed input alternative is selected when the key is released.

12. Method for analysing the signals of a key pad according to claim 1 and claim 10, **characterised in that** the displayed input alternative is selected by increased pressure on a key.

## Revendications

1. Clavier avec des touches (82) actionnables en continu pouvant être pressées et basculées, notamment pour appareils électroniques mobiles, pour l'entrée de données et pour la commande de curseur et la sélection de fonctions, comportant des touches (82) montées de manière mobile et pourvues d'une suspension à ressort (132), qui sur leur côté inférieur sont couplées mécaniquement avec une piste conductrice continue à haute résistance électrique (53), s'étendant sur une ou plusieurs touches de telle sorte que lors d'un actionnement des touches la piste conductrice (53) sur la position d'actionnement contacte une autre piste conductrice à faible résistance électrique (72) s'étendant sur toutes les touches et un convertisseur analogique à numérique AD0 détermine la résistance électrique ou la chute de tension entre la piste conductrice (72) et une extrémité de la piste conductrice (53), dans lequel cette valeur de mesure est évaluée par une unité électronique de commande et de cette manière une touche déterminée et la position d'actionnement est affectée à cette touche.

2. Clavier selon la revendication 1, **caractérisé en ce que** deux convertisseurs analogique à numérique Ad1 et AD2 déterminant la résistance électrique ou la chute de tension entre la piste conductrice (72) et les deux extrémités de la piste conductrice (53) sont prévus, dans lequel ces valeurs de mesure sont affectées de manière univoque à une touche déterminée, à la position d'actionnement comme point sur une ligne et à la surface d'appui (141), (151), (161).

3. Clavier selon la revendication 1, **caractérisé en ce que** les pistes conductrices (53) sont reliées avec une ou plusieurs électrodes de calibrage CAL1, qui permettent une mesure exacte de la résistance électrique sur plusieurs positions de la piste conductrice (53), dans lequel ces mesures servent de points de référence relatifs pour l'interprétation des valeurs de mesure aux deux extrémités de la piste conductrice (53), de telle sorte qu'une mesure exacte soit possible même en cas de fluctuations de la résistance électrique de la piste conductrice totale induites par les températures ou les techniques de production.

4. Clavier selon la revendication 1, **caractérisé en ce que** la piste conductrice (53) du potentiomètre à films en tant que partie intégrante d'un clavier est divisée en plusieurs lignes parallèles les unes aux autres, dans lequel une des extrémités de ces lignes sont respectivement reliées par l'intermédiaire d'une piste conductrice à faible résistance électrique (52) avec l'extrémité située en vis-à-vis de la ligne suivante, de telle sorte que des fluctuations infirmes, induites par la production, de la position de montage des touches (82) sur le potentiomètre à films conduise sur chaque touche au même écart par rapport aux valeurs de mesure.

5. Clavier selon la revendication 1, **caractérisé en ce que** le potentiomètre à films en tant que partie intégrante d'un clavier est constitué d'un film supérieur (51), d'un écarteur (61) et d'un film inférieur (71), qui sont solidement reliés les uns aux autres, dans lequel le film supérieur (51)est imprimé de pistes conductrices à valeur de résistance électrique élevée (53) ainsi que optionnellement de pistes conductrices à valeur de résistance électrique moindre (52) et le film inférieur (71) est imprimé d'une piste conductrice à faible valeur de résistance électrique (72), dans lequel les pistes conductrices (53) et (72) dans la position de repos maintiennent un faible écart de moins de 2 mm l'une de l'autre et se contactent lors de l'actionnement des touches (82).

6. Clavier selon la revendication 1, **caractérisé en ce que** trois convertisseurs analogique à numérique AD1, Ad2 et AD3 déterminant la résistance électrique ou la chute de tension entre la piste conductrice (72) et trois extrémités de la piste conductrice (53)(Fig.9) sont prévues, dans lequel ces valeurs de mesure sont coordonnées de manière univoque à une touche déterminée, à la position d'actionnement comme point sur une surface circulaire et à la surface d'appui (141), (151), (161).

7. Clavier selon la revendication 1, **caractérisé en ce que** sur les touches (82) comme sur un clavier de téléphone numérique sont respectivement inscrits un chiffre ou un symbole et plusieurs lettres de l'alphabet par touche, dans lequel en fonction du mode de fonctionnement des chiffres ou des lettres peuvent être entrés et des lettres différentes peuvent être sélectionnées en fonction de l'actionnement des touches sur la gauche ou la droite de la touche ou le centre de touche.

8. Clavier selon la revendication 1 et 6, **caractérisé en ce que** une touche (121) actionnable sur chaque position de son bord est prévue, dans lequel la direction d'actionnement et l'intensité de la déviation comme point sur une surface circulaire peuvent être définis par le rapport des signaux émis AD1, Ad2 et Ad3 (Fig.3) les unes par rapport aux autres, et la direction et la vitesse d'un mouvement de curseur peut être commandée par la direction et la déviation de cette touche (121).

9. Clavier selon la revendication 1, **caractérisé en ce que** les touches (82) disposent d'une face supérieure de touche (131), une face inférieure de touche (133) convexe et déformable et une suspension flexible (132), de telle sorte qu'une pression mécanique par le haut active un élément de détection de signal (134) situé sur une plaque porteuse (135) sur une position dépendante de la position de déclenchement et avec une surface d'appui (141), (151), (161) dépendante de la pression exercée.

10. Procédé d'estimation des signaux d'un clavier selon la revendication 1, **caractérisé en ce que** les touches en cas d'un léger contact entraînent une représentation de plusieurs alternatives d'entrée sur un écran, dans lequel une de ces alternatives d'entrée est mise en avant par un curseur et la position du curseur est en rapport avec la position du doigt sur la touche.

11. Procédé d'estimation des signaux d'un clavier selon la revendication 1 et 10, **caractérisé en ce que** l'alternative d'entrée affichée est sélectionnée lors du relâchement de la touche.

12. Procédé d'estimation des signaux d'un clavier selon la revendication 1 et 10, **caractérisé en ce que** l'alternative d'entrée affichée est sélectionnée par pression accrue sur une touche.
